# EUROPÄISCHE PATENTANMELDUNG

(11) **EP 1 401 065 A1**
(43) Veröffentlichungstag der Anmeldung: **24.03.2004**
(21) Anmeldenummer: 03400022.4
(22) Anmeldetag: 16.05.2003
(51) Int. Cl.: H01R 43/02, H05K 3/30

(54) **Verfahren zur Fixierung von elektronischen Steckverbindern**

(30) Priorität: 24.08.2002 DE 10238913
(71) Anmelder: Valeo Schalter und Sensoren GmbH, 74321 Bietigheim-Bissingen (DE)
(72) Erfinder: Poslowsky, Georg, 74348 Lauffen (DE); Bodenmüller, Werner, 86744 Hainsfarth (DE)
(74) Vertreter: Bulling, Alexander, Dr.

(57) **Zusammenfassung**

Es wird ein Verfahren zur Fixierung von elektronischen Steckverbindern (1) mit mindestens einer Reihe von Anschlussstiften (2) vorgeschlagen, welche auf einer Leiterplatte (3) einer elektronischen Baugruppe in einer vorbestimmten Position in Stiftlöcher (4) eingesetzt werden, um über ein Befestigungsverfahren anschließend mit der Leiterplatte (3) verbunden zu werden, wobei die Anschlussstifte (2) des Steckverbinders (1) in den Stiftlöchern (4) verklemmt werden.

## Beschreibung

Die Erfindung betrifft ein Verfahren zur Fixierung von elektronischen Steckverbindern auf einer Leiterplatte in einer vorbestimmten Position, um mit der Leiterplatte anschließend elektronisch leitend verbunden zu werden. Insbesondere betrifft die Erfindung ein Fixieren von elektronischen Bauteilen mit Anschlussstiften, die in dafür vorgesehene Stiftlöcher beziehungsweise Lötbohrungen eingesetzt und anschließend durch Verlöten mit der Leiterplatte verbunden werden. Derartige elektronische Stiftleisten beziehungsweise Steckverbinder weisen in der Regel eine Mehrzahl von nebeneinander angeordneten Anschlussstiften auf, wobei es herkömmlicherweise einreihige wie auch mehrreihige Stiftleisten bei elektronischen Bauteilen gibt.

Bisher werden derartige Stiftleisten beziehungsweise mit Anschlussstiften versehene elektronische Bauteile in dafür vorgesehene Löcher beziehungsweise Öffnungen der Leiterplatte eingesteckt und über einen angespritzten Kunststoffkörper, welcher mit Zentrierstiften, Schnapphaken, Verrastungsnasen oder dergleichen versehen ist, auf der Leiterplatte fixiert. Eine Fixierung auf der Leiterplatte ist notwendig, da die Löcher für ein anschließendes Verlöten der Anschlussstifte im Durchmesser regelmäßig größer sind als die Anschlussstifte selbst. Einfache Stiftleisten sind in der Regel jedoch ohne derartige aufwändige Kunststoffkörper beziehungsweise Fixiereinrichtungen ausgeführt und sind lediglich über einen Kunststoffsteg miteinander verbunden. Diese Stiftleisten müssen daher während des Lötvorgangs oder des anderweitigen Verbindens mit der Leiterplatte, wie zum Beispiel Clinchen, gegen ein Herausfallen gesichert und/oder in der gewünschten Position fixiert und gehalten werden.

Entweder waren bisher gemäß Stand der Technik somit aufwändige Zusatzeinrichtungen zur Fixierung der Steckverbinder oder der Bauteile erforderlich, oder es bestand bei einfachen, zum Beispiel einreihigen Stiftleisten die Gefahr, dass beim Einlöten beziehungsweise Befestigen die Lötposition nicht genau eingehalten und zum Beispiel ein Steckverbinder schräg eingelötet wurde.

Demgegenüber ist es die Aufgabe der vorliegenden Erfindung, ein Verfahren zur Fixierung von elektronischen Steckverbindern oder Bauteilen bereitzustellen, welches möglichst einfach ist, keine zusätzlichen Kosten verursacht und in bestehende Herstellungs- und Montageprozesse für elektronische Baugruppen leicht zu integrieren ist.

Diese Aufgabe wird durch ein Verfahren mit den Schritten gemäß Anspruch 1 gelöst. Vorteilhafte Ausgestaltungen und Weiterbildungen der Erfindung sind Gegenstand der abhängigen Ansprüche.

Gemäß der Erfindung wird zur Fixierung der elektronischen Steckverbinder, die mindestens eine Reihe von nebeneinander angeordneten Anschlussstiften aufweisen und auf einer Leiterplatte in einer vorbestimmten Position in Stiftlöcher eingesetzt werden, um mit der Leiterplatte verbunden zu werden, die Reihe der Anschlussstifte des Steckverbinders in den Stiftlöchern vorab verklemmt. Unter Verklemmen wird hier das Erzeugen einer leichten Klemmwirkung beziehungsweise Klemmkraft verstanden, die ausreichend ist, um ein Verrutschen der Anschlussstifte in den Stiftlöchern oder ein Kippen der Stiftleiste zu verhindern. Hierdurch kann auf denkbar einfache Weise, nämlich durch Variieren des Abstandes entweder der Anschlussstifte zueinander oder der Stiftlöcher für die Anschlussstifte, das Bauteil beziehungsweise die Stiftleiste in ihrer exakten Position jeweils vor dem Verlöten eingeführt und fixiert werden. Aufwändige Zusatzeinrichtungen, wie Klemmgehäuse oder Zentrier- und Fixierstifte, werden so vermieden, und der Raumbedarf für den elektrischen Verbinder auf der Leiterplatte wird somit nicht unnötig erhöht. Durch die (relativ geringe) Klemmkraft wird außerdem eine genauere Endposition der Stiftleiste erreicht, weil ein Verschwimmen der Stiftleiste in den im Durchmesser für das anschließende Verlöten beziehungsweise den Lotdurchstieg größeren Stiftlöchern vermieden wird. Das erfindungsgemäße Verfahren ist kostengünstig, da lediglich einer oder mehrere Abstände der Stiftlöcher beim Bohren derselben leicht verändert werden müssen.

Nach einer vorteilhaften Ausgestaltung der Erfindung wird mindestens einer der Abstände zwischen den Stiftlöchern im Verhältnis zu den Abständen der Anschlussstifte selbst vergrößert. Unter Vergrößern wird hier ein leichtes Vergrößern des Abstandes verstanden, gerade so, dass eine leichte Reibung und damit Klemmung zwischen dem Anschlussstift und der Wandung des Stiftlochs erzeugt wird. Hierdurch wird insgesamt eine Stiftleiste ausreichend für ein kurzfristiges Halten beziehungsweise Fixieren geklemmt, da schon bei Verändern eines Abstandes die anderen Stifte ebenfalls leicht in ihren Stiftlöchern automatisch mitgeklemmt werden.

Nach einer weiteren vorteilhaften Ausgestaltung der Erfindung werden jeweils die Abstände der äußeren Stiftlöcher einer Reihe von Anschlussstiften eines Steckverbinders vergrößert. Ähnlich wie dem Auseinanderspreizen von "Beinen" werden so die äußeren Anschlussstifte leicht im Verhältnis zu ihrer Ausgangslage auseinandergespreizt und in einen vorgespannten Zustand in ihrer Position auf der Leiterplatte gehalten. Durch jeweiliges Ändern der Abstände der äußeren Anschlussstifte bzw. ihrer jeweiligen Stiftlöcher wird beiderseits der Stiftleiste eine für das Fixieren erforderliche Klemmung erzeugt, sodass die Stiftleiste auch nicht schräg im Verhältnis zur Leiterplatte verlötet werden kann.

Nach einer weiteren vorteilhaften Ausgestaltung der Erfindung wird eine Vorspannung an die Anschlussstifte derart angelegt, dass ein im Wesentlichen reibungsloses Einsetzen in die Stiftlöcher ermöglicht wird. Anschließend wird dann die Vorspannung zum Verklemmen des Steckverbinders gelöst. Im vorgespannten Zustand wird so der Steckverbinder zum Beispiel über einen Greifer so bereitgestellt, dass am unteren Ende der Anschlussstifte die äußeren Anschlussstifte etwas auseinandergedrückt werden, sodass sie den leicht vergrößerten Abstand der äußeren Stiftlöcher ausgleichen und ohne direkte Klemmung oder Reibung in die Löcher eingeführt werden können. Nach Erreichen der vorbestimmten Position des Steckverbinders kann die Vorspannung gelöst werden, sodass die erfindungsgemäße leichte Klemmung in den Anschlussstiften aufgebaut wird für ein Vorfixieren vor dem Verlötvorgang oder einem anderen Befestigungsvorgang der Anschlussstifte.

Nach einer weiteren vorteilhaften Ausgestaltung der Erfindung wird ein einreihiger Steckverbinder fixiert. Besonders bei einreihigen Steckverbindern besteht das Problem, dass ein zusätzliches Fixierelement den Raumbedarf des Steckverbinders oder elektronischen Bauteils auf der Leiterplatte erheblich vergrößert. Zudem ist bei einreihigen, zum Beispiel zwei-, drei- oder vier-poligen Steckverbindern die Gefahr eines Verkippens und damit schrägen Befestigens auf der Leiterplatte besonders groß.

Nach einer weiteren vorteilhaften Ausgestaltung der Erfindung ist das anschließende Befestigungsverfahren ein Lötvorgang. Die Steckverbinder können vorteilhaft leicht in den Löchern für die Anschlussstifte eingeklemmt und anschließend durch Verlöten der Stifte von der Unterseite, das heißt dem freien Stiftende, verlötet werden, wobei das Lot durch die Stiftlöcher durchtritt (Lotdurchgang) und der Steckverbinder, obwohl kopfüber, gegen ein Herausfallen kurzfristig und auf einfache Weise gesichert ist.

Weitere Merkmale, vorteilhafte Ausgestaltungen und Einzelheiten der Erfindung sind der nachfolgenden Beschreibung zu entnehmen, in welcher die Erfindung anhand des in der Zeichnung dargestellten Ausführungsbeispiels näher beschrieben und erläutert ist.

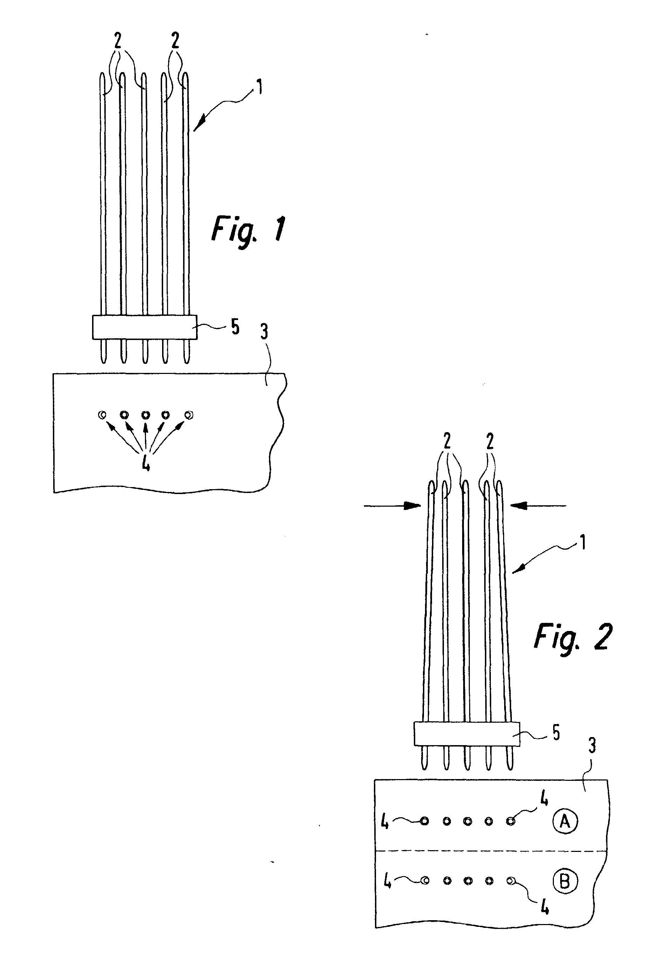

In Figur 1 ist ein erstes Ausführungsbeispiel der Erfindung schematisch dargestellt. Ein elektrischer Steckverbinder 1 weist vier parallel und in Reihe angeordnete Anschlussstifte 2 auf, die mittels eines Kunststoffsteges 5 miteinander verbunden sind. Der Steckverbinder 1 ist dazu vorgesehen, auf einer Leiterplatte 3 einer elektronischen Baugruppe in Stiftlöcher 4 eingesetzt zu werden. Die Stiftlöcher 4 sind erfindungsgemäß so vorgesehen, dass jeweils die beiden äußeren Stiftlöcher 4 einen größeren Abstand zu den anderen Stiftlöchern aufweisen, das heißt leicht versetzt nach außen in Bezug auf die inneren drei Stiftlöcher sind. Hierdurch werden die unteren Enden der Anschlussstifte 2 beim Einsetzen in die Leiterplatte 3 verklemmt, da die äußeren beiden Stiftenden nach außen in die versetzt angeordneten äußeren Stiftlöcher 4 geklemmt werden. Es wird hierbei jeweils an den äußeren Anschlussstiften 2 eine Klemmkraft erzeugt, die ausreichend ist, den Steckverbinder 1 in der vorgesehenen Position und Lage zu halten, obwohl der Durchmesser der Stiftlöcher 4 größer als der Durchmesser der Anschlussstifte 2 ist. Dies ermöglicht ein Verlöten des Steckverbinders 1 in einer vorab fixierten Position, ohne dass ein Verrutschen droht und ohne dass aufwändige Halte- oder Fixiereinrichtungen zusätzlich erforderlich sind.

In Figur 2 ist ein zweites Ausführungsbeispiel der Erfindung schematisch dargestellt. Im Unterschied zum vorhergehenden Ausführungsbeispiel sind hier die Anschlussstifte 2 vorab derart unter eine Vorspannung gesetzt, dass zum Einsetzen des Steckverbinders 1 in die vorgesehenen Stiftlöcher 4 auf der Leiterplatte 3 ein im Wesentlichen reibungsloses Einsetzen ermöglicht wird und erst nach Lösen der Vorspannung die erfindungsgemäße leichte Klemmwirkung erzeugt wird. Bei diesem Ausführungsbeispiel sind ebenfalls die Stiftlöcher 4 an den äußeren Enden der Reihe mit jeweils einem größeren Abstand als zwischen den mittleren Stiftlöchern 4 vorgesehen, damit die gleichmäßig beabstandeten Anschlussstifte 2, die durch den Kunststoffsteg 5 im Abstand zueinander gehalten werden, bei Lösen der Vorspannung leicht in den Stiftlöchern 4 geklemmt werden. Die Vorspannung, welche in der Figur 2 mittels seitlicher Pfeile angedeutet ist, kann durch jedes geeignete Mittel, wie zum Beispiel einen Greifer, eine Klemme oder dergleichen, erzeugt werden. Bei A ist eine Draufsicht auf die Löcher mit eingesteckten Stiften zu sehen, während des Einsetzvorgangs, bei welchem die Anschlussstifte 2 im Wesentlichen reibungslos in die im Durchmesser größeren Stiftlöcher 4 einführbar sind. Bei B ist eine Draufsicht nach dem Einsetzvorgang dargestellt, in welchem dann die äußeren Anschlussstifte 2 jeweils in Richtung nach innen gegen die Wände ihrer Stiftlöcher 2 gedrückt werden, sodass eine leichte Klemmkraft für die gesamte Stiftleiste 1 erzeugt wird.

Sämtliche in der Beschreibung, den nachfolgenden Ansprüchen und der Zeichnung dargestellten Merkmale können sowohl einzeln als auch in beliebiger Kombination miteinander erfindungswesentlich sein.

## Patentansprüche

1. Verfahren zur Fixierung von elektronischen Steckverbindern (1) mit mindestens einer Reihe von Anschlussstiften (2), welche auf einer Leiterplatte (3) in einer vorbestimmten Position in Stiftlöcher (4) eingesetzt werden, um über ein Befestigungsverfahren anschließend mit der Leiterplatte (3) verbunden zu werden,
**gekennzeichnet durch**
Verklemmen der Anschlussstifte (2) des Steckverbinders (1) in den Stiftlöchern (4).

2. Verfahren nach Anspruch 1, **gekennzeichnet durch** Vergrößern von mindestens einem der Abstände zwischen den Stiftlöchern (4) im Verhältnis zu den Abständen der Anschlussstifte (2).

3. Verfahren nach Anspruch 1 oder 2, **gekennzeichnet durch** Vergrößern der Abstände der jeweiligen äußeren Stiftlöcher (4) eines Steckverbinders (1).

4. Verfahren nach einem der vorhergehenden Ansprüche, **gekennzeichnet durch** Anlegen einer Vorspannung an die Anschlussstifte (2) derart, dass ein im Wesentlichen reibungsloses Einsetzen in die Stiftlöcher (4) ermöglicht wird, und anschließendes Lösen dieser Vorspannung zum Verklemmen des Steckverbinders (1).

5. Verfahren nach einem der vorhergehenden Ansprüche, **gekennzeichnet durch** Fixieren eines einreihigen Steckverbinders (1) mit einer Mehrzahl von Anschlussstiften (2).

6. Verfahren nach einem der vorhergehenden Ansprüche, **gekennzeichnet durch** anschließendes Verlöten der Anschlussstifte (2) mit der Leiterplatte (3).
